# EUROPEAN PATENT SPECIFICATION

(11) **EP 3 235 644 B1**
(45) Date of publication and mention of the grant of the patent: **12.08.2020**
(21) Application number: 17161476.1
(22) Date of filing: 17.03.2017
(51) Int. Cl.: B41J 2/14

(54) **INK JET HEAD AND INK JET RECORDING APPARATUS**
TINTENSTRAHLKOPF UND TINTENSTRAHLVORRICHTUNG
TÊTE À JET D'ENCRE ET IMPRIMANTE À JET D'ENCRE

(30) Priority: 20.04.2016 JP 2016084587
(43) Date of publication of application: 25.10.2017
(73) Proprietor: Toshiba TEC Kabushiki Kaisha, Tokyo 141-0032 (JP)
(72) Inventor: WONG, Meng Fei, Shinagawa-ku, Tokyo 141-8562 (JP); KUSUNOKI, Ryutaro, Shinagawa-ku, Tokyo 141-8562 (JP); YOKOYAMA, Shuhei, Shinagawa-ku, Tokyo 141-8562 (JP); ARAI, Ryuichi, Shinagawa-ku, Tokyo 141-8562 (JP)
(74) Representative: Bandpay & Greuter

(56) References cited:
- JP-A- H09 272 206
- US-A1- 2007 070 128
- US-A1- 2010 134 564
- US-A1- 2013 070 027
- US-B2- 6 474 786

## Description

### FIELD

The present invention relates to the field of an inkjet recording technology in general, and embodiments described herein relate in particular to an ink jet head, an ink jet recording apparatus and corresponding system, and a method for performing an ink jet recording.

### BACKGROUND

Generally, a piezoelectric ink jet head includes a nozzle substrate with piezoelectric material. This ink jet head can include a plurality of piezoelectric actuators, each having a nozzle at one end of a corresponding pressure chamber.

In conventional ink jet heads, an actuator includes a piezoelectric body on a vibrating plate, a common electrode electrically connected to the piezoelectric body, and an individual electrode electrically connected to the piezoelectric body. The piezoelectric body is interposed between the individual electrode and the common electrode. Wiring patterns connected to the individual electrode and the common electrode respectively are separated from each other without overlapping on the vibrating plate.

Printing quality can be improved by adopting a high density nozzle array. For such design, a wiring pattern is electrically connected to a portion between adjacent actuators in order to perform wiring of a plurality of conductive patterns of the common electrode, while another wiring pattern is connected to the individual electrode of each actuator.

US 2007/070128 A1 discloses a piezoelectric element including a piezoelectric body and top and bottom electrodes holding the piezoelectric body therebetween.

US 2013/070027 A1 discloses an inkjet head including actuators configured to pressurize ink.

Compared to the prior disclosure, the present invention provides an inkjet head, apparatus and system, and a method as defined in the appended claims.

### DESCRIPTION OF THE DRAWINGS

The above and other objects, features and advantages of the present invention will be made apparent from the following description of the preferred embodiments, given as non-limiting examples, with reference to the accompanying drawings, in which:
FIG. 1 is a perspective view illustrating an ink jet head according to a first embodiment.
FIG. 2 is a plan view illustrating a partial configuration of the flow path substrate according to the first embodiment.
FIG. 3 is a partially enlarged view of FIG. 2, and a plan view illustrating the detail of an actuator.
FIG. 4 is a sectional view taken along line IV-IV in FIG. 3.
FIGS. 5A and 5B illustrate the hysteresis and the butterfly displacement curve of a ferroelectric body.
FIG. 6 is a plan view illustrating a wiring pattern according to a second embodiment.
FIG. 7 is a partially enlarged view of a wiring pattern according to a third embodiment, and a plan view illustrating the detail of an actuator.
FIG. 8 is a schematic view of an ink jet recording apparatus including the ink jet head according to the first embodiment.

### DETAILED DESCRIPTION

For an apparatus with a configuration described in the relevant literature, when electrical breakdown occurs causing disconnection in the wiring connected to the common electrode, some of the actuators are disconnected from the common electrode.

According to one embodiment, an ink jet head and an ink jet recording apparatus that can reliably maintain an electrical connection even when any one common electrode in the high density nozzle array is disconnected are provided.

In general, according to one embodiment, an ink jet head includes a plurality of nozzles and a plurality of actuators corresponding to this plurality of nozzles. The plurality of actuators causes ink to be ejected from the plurality of nozzles by pressurizing the ink. Each actuator includes a piezoelectric body, a common electrode, and an individual electrode. The individual electrode is electrically connected to an individual portion of a first wiring pattern disposed on a vibrating plate. Each of the common electrodes of the actuators is connected to a second wiring pattern disposed on the vibrating plate separated from the first wiring pattern. The second wiring pattern is electrically connected to a wiring portion that passes between the outer peripheral portions of the plural piezoelectric bodies. A third wiring pattern is disposed on the vibrating plate, extends in a direction different from a direction of the second wiring pattern, and is electrically connected to the second wiring pattern. The first wiring pattern and the third wiring pattern are electrically isolated at intersections thereof.

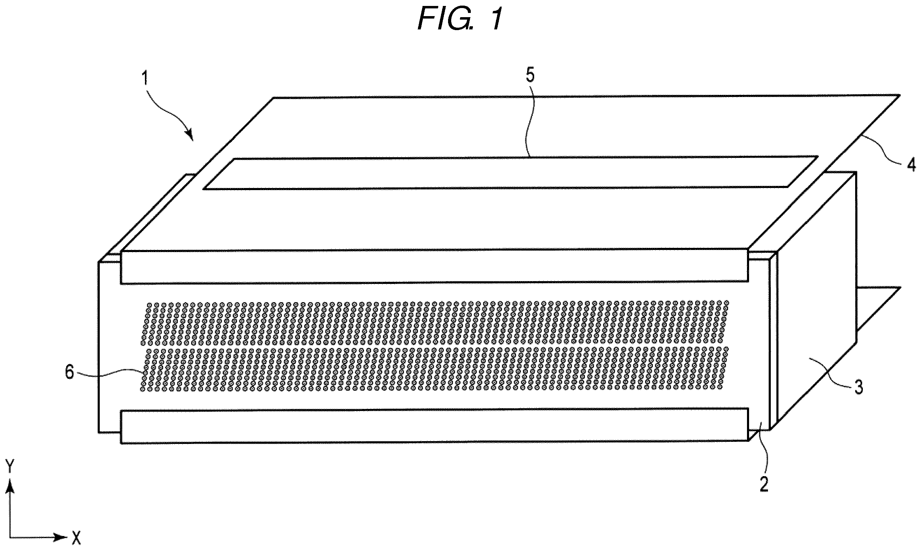

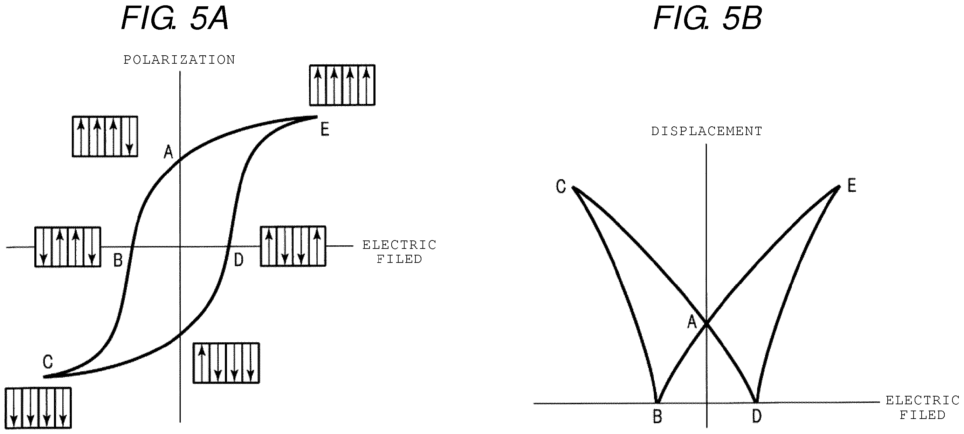

Hereinafter, the first embodiment will be described with reference to FIGS. 1 to 5A and 5B. There is a case of using other expressions of one or more in each element which can be expressed, using a plurality of expressions. However, it is not a situation of denying a case of using a different expression with respect to an element in which another expression is not used, and also is not a situation of limiting a case of using another expression which is not exemplified. In addition, each figure schematically illustrates the embodiment, and there is a case in which a dimension of each element illustrated in figures is different from descriptions in the embodiment. The above embodiments can be applied mutatis mutandis to a ink jet recording system comprising the corresponding means.

Hereinafter, a wiring pattern of an ink jet head 1 according to the embodiment will be described. Each figure is schematically plotted for promoting easier understanding. Since there may be cases where a portion in which a shape, a dimension, a proportion, or the like, thereof is different, designs thereof can be appropriately modified.

FIG. 1 is an external perspective view illustrating the ink jet head 1 according to a first embodiment.

The ink jet head 1 includes a flow path substrate 2, an ink supply unit 3, flexible wiring boards 4, and driving circuits 5.

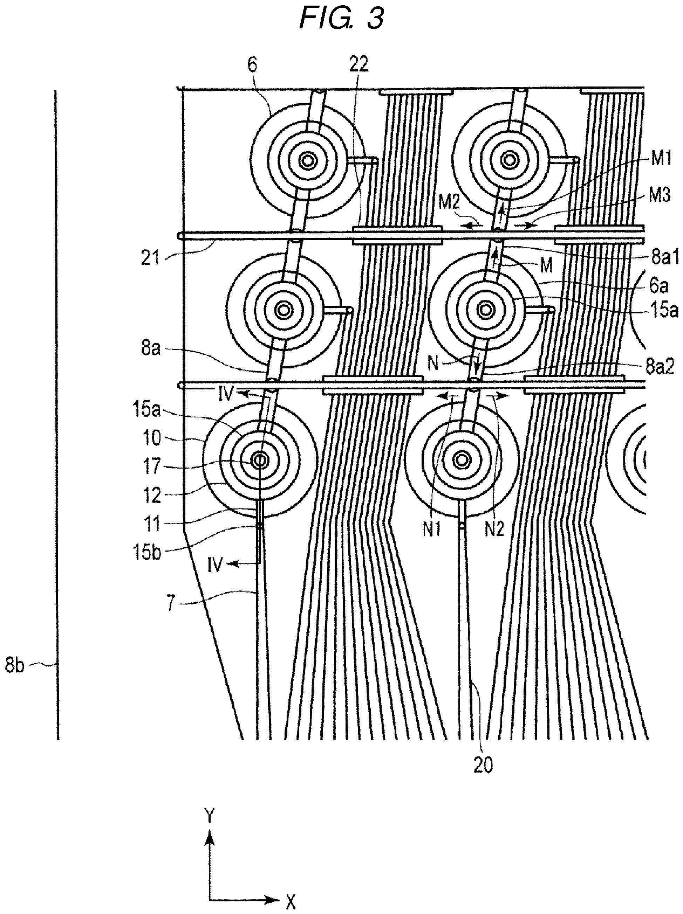

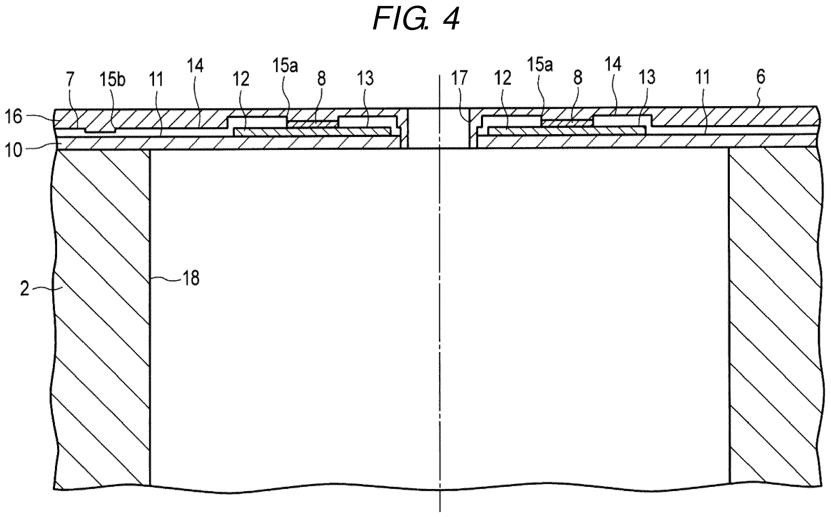

Actuators 6 that eject the ink from nozzles 17 (illustrated in FIGS. 3 and 4 described below) are arranged in an array on the flow path substrate 2. A plurality of the nozzles 17 are linearly arranged in an oblique direction and at a constant angle with respect to a Y direction, which is the transportation direction of the recording sheet P (a recording medium). In addition, in FIG. 1, an arrow X denotes a longitudinal direction of the ink jet head 1. The longitudinal direction of the ink jet head 1 denotes a direction orthogonal to the transportation direction of the recording sheet P denoted by an arrow Y, and coincides with the width direction of the recording sheet P.
Nozzles 17 are arranged at even intervals in a direction orthogonal to a printing direction without overlapping each other in the printing direction. Each actuator 6 is electrically connected to the driving circuits 5 through the flexible wiring boards 4. The driving circuits 5 are electrically connected to a control circuit (not illustrated), which performs printing control. The flow path substrate 2 and the flexible wiring boards 4 are bonded together and are electrically connected using an anisotropic conductive film (ACF). The flexible wiring boards 4 and the driving circuits 5 are bonded together and electrically connected using chip on flex (COF), for example.

The ink supply unit 3 includes an ink supply port (not illustrated), which is connected to a tube or the like and supplies ink through the ink supply port to the flow path substrate 2. The flow path substrate 2 and the ink supply unit 3 are bonded together using, for example, an epoxy-based adhesive.

When the ink is supplied from the ink supply port and the driving circuit 5 sends an electric signal (also referred to as driving signal) to the actuator 6, the actuator 6 vibrates, pressurizing the ink filled in a pressure chamber 18 (illustrated in FIG. 4 described below) inside of the flow path substrate 2. The ink is then ejected from the nozzle 17, in which the actuator 6 is disposed, in a direction perpendicular to the surface of the flow path substrate 2. In other words, the driving circuit 5 supplies an electric signal to the actuator 6. The actuator 6 causes a pressure vibration in ink by changing the volume of the pressure chamber 18 according to the electric signal. In this manner, the nozzle 17 ejects the ink from the pressure chamber 18.

In an embodiment, ink is supplied to the ink supply port at a pressure that is lower than the atmospheric pressure by approximately 1000 Pa.

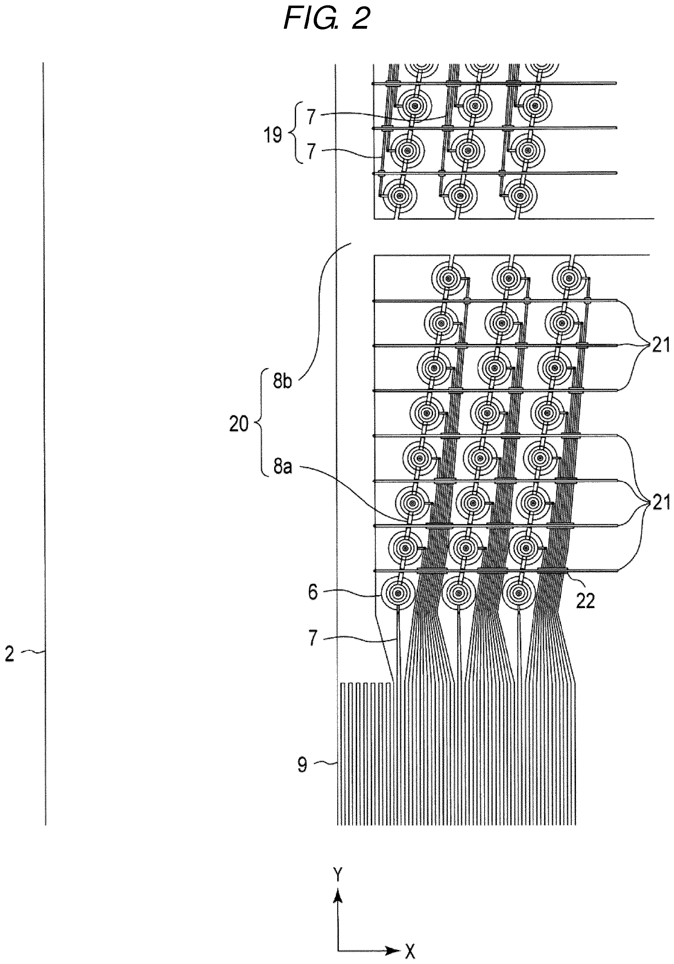

FIG. 2 illustrates a plan view of a wiring pattern on the flow path substrate 2 according to the first embodiment. The portion in which the same wiring pattern is repeated is omitted. A plurality of the actuators 6, a plurality of the individual electrodes 7, common electrodes 8a and 8b, and a plurality of mounting pads 9 are formed on the flow path substrate 2. The common electrodes 8a or 8b may be generally referred as the common electrode 8.

The mounting pad 9 is electrically connected to the driving circuit 5 through the plurality of wiring patterns formed on the flexible wiring board 4. An anisotropic conductive film (ACF) can be used to connect the mounting pad 9 and the flexible wiring board 4. In addition, the mounting pad 9 may be connected to the driving circuit 5 using a method such as wire bonding or the like.

Each individual electrode 7 is connected to each actuator 6 individually and independently. The first wiring pattern 19 includes a plurality of individual electrodes 7, which are individually and independently provided.

The second wiring pattern 20 includes a plurality of common electrodes 8a and 8b. The common electrode 8b is electrically connected to the mounting pad 9 at an end portion. The common electrode 8a branches off from the common electrode 8b, and is electrically connected to a plurality of actuators 6 that are adjacent to each other.

FIG. 3 is a plan view illustrating an enlarged view of wiring patterns of the flow path substrate 2. FIG. 4 is a vertical sectional view of the flow path substrate 2 taken along the line IV-IV in FIG. 3.

As illustrated in FIG. 4, an actuator 6 includes a vibrating plate 10, a lower electrode 11, a piezoelectric body 12, an upper electrode 13, a first insulating layer 14, a common electrode 8, a protective layer 16, and a nozzle 17.

The flow path substrate 2 includes a single crystal silicon wafer with a thickness of 500 µm, as an example. A plurality of pressure chamber 18, which is filled with ink, is formed inside the flow path substrate 2. The diameter of the pressure chamber 18 is set as 200 µm, as an example. The pressure chamber 18 is formed by forming a hole from the lower surface of the flow path substrate 2 using dry etching, for example.

A vibrating plate 10 is integrally formed on the flow path substrate 2 to cover the top surface of the pressure chamber 18. The vibrating plate 10 includes silicon dioxide, which is a silicon oxide film formed using thermal oxidation, by heating the single crystal silicon wafer of the flow path substrate 2 at a high temperature before forming the pressure chamber 18. A through hole, which is larger than the nozzle 17, is formed in the vibrating plate 10 concentric with the nozzle 17. The thickness of the vibrating plate 10 is set as 4 µm, as an example.

A stacked body of the lower electrode 11, the piezoelectric body 12, and the upper electrode 13 is formed on the vibrating plate 10 in a toroidal shape around the nozzle 17. The inner and outer diameter of the stacked body is set as 30 µm and 140 µm, respectively, as an example. The lower electrode 11, the piezoelectric body 12, and the upper electrode 13 are, as an example, films of platinum, lead zirconate titanate (PZT), and platinum, respectively, formed by sputtering method. The thickness of the upper electrode 13 and the lower electrode 11 is set as 0.1 µm to 0.2 µm, respectively, as an example. The thickness of the PZT is set as 2 µm, as an example. In addition, PZT may be formed as a film using the sputtering method or the like.

The piezoelectric body 12 has an orientation direction (polarization direction) that is determined during the formation of the film and causes polarization in the thickness direction. According to the embodiment whereby the piezoelectric body 12 is formed as a film on the lower electrode 11 using sputtering method, the polarization direction of the piezoelectric body film is oriented from the lower electrode 11 toward the upper electrode 13.

FIGS. 5A and 5B illustrate characteristics (A), which are referred to as hysteresis of the piezoelectric body 12 as a ferroelectric, and characteristics (B), which are referred to as a butterfly displacement curve. As illustrated in FIGS. 5A and 5B, when applying an electric field with a direction opposite to the polarization direction to the piezoelectric body 12 (A→B→C), displacement decreases with the intensity of the electric field from A to B, but increases from B to C. This complicates operating characteristics of the actuator 6 and causes difficulty in controlling its displacement. On the other hand, by applying an electric field in the same direction as the polarization direction of the piezoelectric body 12 (A→E), control thereof becomes less complicated since the displacement monotonously increases with the increase in the intensity of the electric field. Accordingly, it is preferable to apply an electric field in the same direction as the polarization direction, like (A→E), rather than applying an electric field in a direction opposite to the polarization direction, like (A→B→C), since displacement is approximately proportional to the electric field.

In addition, it is known that a cost of a driving IC or a power supply device that supplies a negative voltage is high (approximately several to several tens of times), compared to that for a positive voltage. Accordingly, in order to perform driving by applying an electric field in the same direction as the polarization direction of the piezoelectric body 12, and cause liquid to be ejected from the nozzle 17, a first method of applying a positive voltage to the upper electrode 13 from a driving source can be employed. The first method includes applying the positive voltage to the upper electrode 13 and setting the lower electrode 11 to ground. Alternatively, a second method can be employed by applying the positive voltage to the lower electrode 11 and setting the upper electrode 13 to ground. The second method is preferred over the first method to avoid additional step of performing polarization reverse process in order to orient the polarization direction of the piezoelectric body 12 from the upper electrode 13 toward the lower electrode 11.

When an electric field is applied only in the same direction as the polarization direction, the piezoelectric body 12 extends in the film thickness direction as a result of the applied electric field and contracts in a direction orthogonal to the film thickness (in-plane direction).

As illustrated in FIG. 4, the first insulating layer 14 is formed on the upper electrode 13. Two contact holes (first contact hole 15a and second contact hole 15b) are formed on the first insulating layer 14. The first contact hole 15a is an opening formed in a toroidal shape, and the upper electrode 13 and the common electrode 8 are electrically connected through the first contact hole 15a. The second contact hole 15b is a circular opening formed at a position corresponding to the peripheral wall portion of the pressure chamber 18 of the flow path substrate 2,through which the lower electrode 11 and the individual electrode 7 are electrically connected.

The first insulating layer 14 is obtained by forming a silicon dioxide film using, as an example, a tetraethoxysilane (TEOS)-chemical vapor deposition (CVD) method. The thickness of the first insulating layer 14 is 0.5 µm, as an example. The first insulating layer 14 prevents the common electrode 8 and the lower electrode 11 from being in electrical contact at the outer peripheral portion of the piezoelectric body 12.

The individual electrode 7, the common electrode 8, and the mounting pad 9 are formed on the first insulating layer 14. The individual electrode 7 is connected to the lower electrode 11 through the second contact hole 15b. The common electrode 8 is connected to the upper electrode 13 through the first contact hole 15a. The individual electrode 7, the common electrode 8, and the mounting pad 9 are fabricated by forming a film using gold, using a sputtering method, as an example. The thickness thereof is set as 0.1 µm to 0.5 µm, as an example.

A protective layer 16 is formed on the individual electrode 7, the common electrode 8, and the first insulating layer 14. A circular nozzle 17, which communicates with the pressure chamber 18, is open to the protective layer 16. A thickness of the protective layer 16 is set as 4 µm, as an example, and a diameter of the nozzle 17 is set as 20 µm, as an example. The protective layer 16 is obtained by forming a film using a photosensitive polyimide material, using spin coating method, as an example. The nozzle 17 is fabricated by performing exposer developing with respect to the photosensitive polyimide material, which is the protective layer 16, as an example.

The first wiring pattern 19 and the second wiring pattern 20 are separated without being electrically connected to each other on the vibrating plate 10.

In addition, according to the embodiment, a third wiring pattern 21 is formed. The third wiring pattern 21 is electrically connected to the second wiring pattern 20 at intersections with the common electrode 8a. In order to prevent the third wiring pattern 21 from causing an electrical short-circuit with the first wiring pattern 19, a second insulating layer 22 is interposed between the third wiring pattern 21 and the first wiring pattern 19 at points of intersection, as an example.

The following describes the operational effect with the aforementioned configuration. An actuator 6a as one of the plurality of actuators 6 in FIG. 3 will be described as an example. A current path of the actuator 6a extends from the individual electrode 7 and the second contact hole 15b to the first contact hole 15a and the common electrode 8a through the piezoelectric body 12. There are two possible main current paths (M and N) from the first contact hole 15a, where the current path M is through a common electrode 8a1, which extends in an upper direction of the actuator 6a, and the current path N is through a common electrode 8a2, which extends in a lower direction in FIG. 3. In addition, due to a connection between the second wiring pattern 20 and the third wiring pattern 21, three current sub-paths (M1, M2, and M3) extend from the main current path M. Two current sub-paths(N1 and N2) extend from the main current path N. In this manner, the current path from one actuator 6a includes five current sub-paths in total.

Therefore, according to the embodiment, the upper electrode 13 of the actuator 6 is connected to a common electrode 8a of the second wiring pattern 20, disposed between the outer peripheral portions of the plural piezoelectric bodies 12. The second wiring pattern 20 is electrically connected to ground and the third wiring pattern 21. The first wiring pattern 19 intersects the third wiring pattern 21 without being electrically connected thereto by interposing a second insulating layer 22. In this manner, since a plurality of current paths (sub-paths) are formed for the common electrodes 8 for all actuators 6, even when any of the common electrodes 8 of the plurality of current paths (sub-paths) is disconnected, it is possible to maintain an electrical connection through another common electrode 8 that is not disconnected. For this reason, it is possible for the actuator 6 to secure a connection with the common electrode 8, even when there is a disconnection or electrical breakdown in any one of the plurality of current paths (sub-paths).

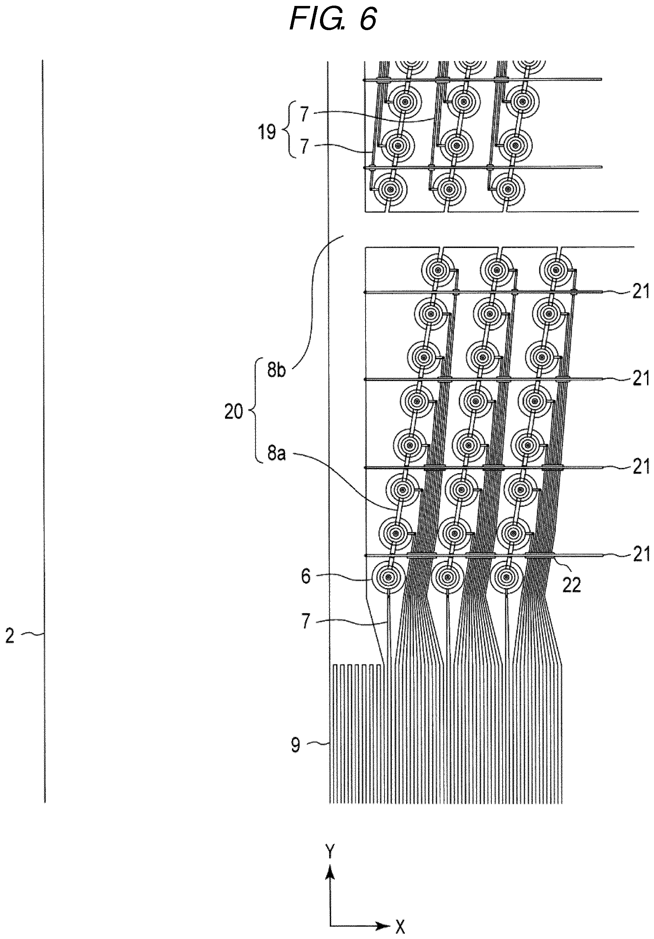

Subsequently, a second embodiment will be described with reference to FIG. 6. In the embodiment, the third wiring pattern 21 according to the first embodiment is modified as follows. That is, in FIG. 6, a configuration in which the number of third wiring patterns 21 that extend in the X direction is reduced compared to that according to the first embodiment. In addition, one common electrode 8 of the third wiring pattern 21 is arranged in respective two actuators 6 that are adjacent to each other in the Y direction. Also in this case, as the first embodiment, all of the actuators 6 can form a plurality of current paths (subs-paths) in the common electrode 8, respectively. For this reason, it is possible for the actuator 6 to secure a connection with the common electrode 8, even when a disconnection or electrical breakdown occurs in any one of the plurality of current paths (subs-paths).

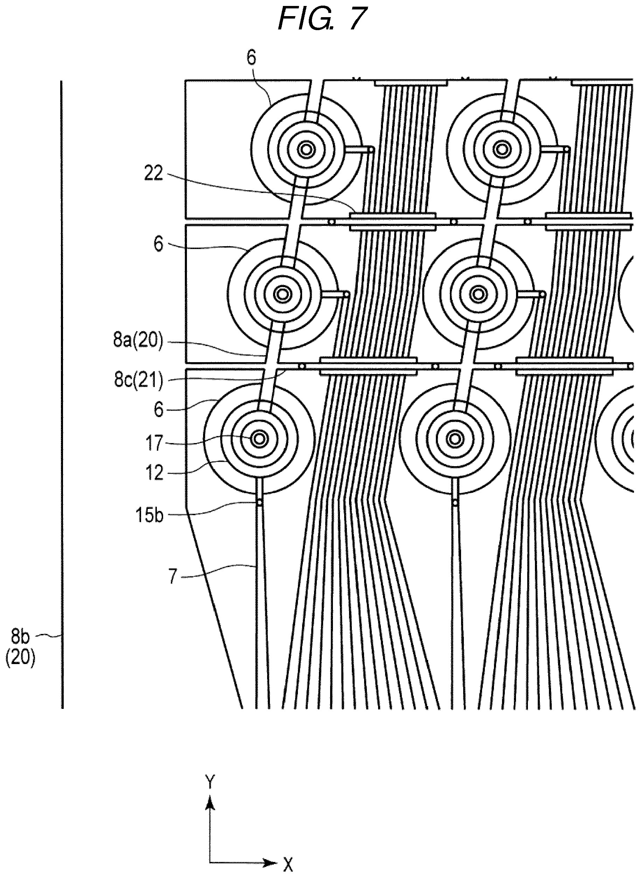

FIG. 7 is a plan view illustrating a partially enlarged view of a wiring pattern according to a third embodiment, and a plan view of a detail of an actuator. According to the embodiment, the first wiring pattern 19 includes a plurality of individual electrodes 7, similar to the first embodiment.

Unlike the first embodiment, the second wiring pattern 20 includes a common electrode 8c, which branches off from the common electrode 8a and extends onto the vibrating plate 10, in addition to the common electrodes 8a and 8b. The second wiring pattern 20 includes the plurality of common electrodes 8a, 8b, and 8c, and is separated from the first wiring pattern 19 without being electrically connected thereto. In addition, the third wiring pattern 21 includes the common electrode 8c, and is electrically connected to the second wiring pattern 20 through the common electrode 8c.

Like the first embodiment, according to the embodiment, in each actuator 6, two or more current paths are created, and it is possible to secure a connection with the common electrode 8 even when there is a disconnection or electrical breakdown in any one of the current paths.

According to the embodiment, a portion of the third wiring pattern is integrated with the second wiring pattern 20 using the common electrode 8c. For this reason, according to the embodiment, the number of steps or level differences of the common electrode 8a and the second insulating layer 22, over which the third wiring pattern 21 is disposed, is halved as compared to a case in which the third wiring pattern 21 is formed separately from the common electrode 8a, like the first embodiment. For this reason, it is possible to reduce a risk of a disconnection or a high resistance between the third wiring pattern 21 and the common electrode 8.

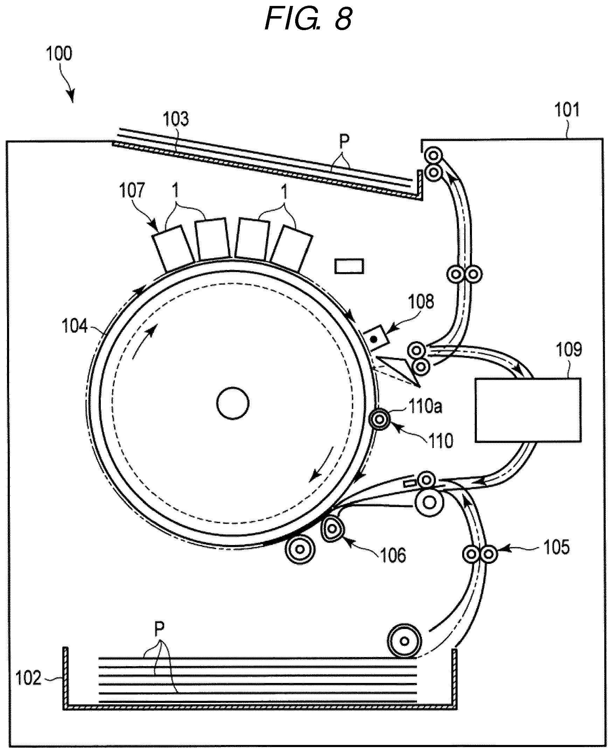

Subsequently, an ink jet recording apparatus 100 including the above described ink jet head 1 will be described with reference to FIG. 8. FIG. 8 is a schematic view for describing an example of the ink jet recording apparatus 100. The ink jet recording apparatus 100 also can be referred to as an ink jet printer. In addition, the ink jet recording apparatus 100 may be a device such as a copier.

The ink jet recording apparatus 100 performs various processings, such as forming an image while transporting a recording sheet P as a recording medium, or the like. The ink jet recording apparatus 100 includes a housing 101, a sheet feeding cassette 102, a sheet discharging tray 103, a holding roller (drum) 104, a transport unit 105, a holding unit 106, an image forming unit 107, a neutralizing and separating unit 108, a reversing unit 109, and a cleaning unit 110.

The housing 101 accommodates each unit of the ink jet recording apparatus 100.

The sheet feeding cassette 102 is arranged inside the housing 101 while accommodating a plurality of recording sheets P.

The sheet discharging tray 103 is located above the housing 101. The recording sheet P on which an image is formed by the ink jet recording apparatus 100 is discharged to the sheet discharging tray 103.

The holding roller 104 includes a cylindrical frame that includes a conductive body, and a thin insulating layer formed on the surface of the frame. The frame is grounded (connected to ground). The holding roller 104 transports the recording sheet P by rotating in a state of holding the recording sheet P on the surface thereof.

The transport unit 105 includes a plurality of guides and transport rollers that are arranged along a path through which the recording sheet P is transported. The transport roller rotates by being driven by a motor. The transport unit 105 transports the recording sheet P to which ink ejected from the ink jet head 1 is attached from the sheet feeding cassette 102 to the sheet discharging tray 103.

The holding unit 106 causes the recording sheet P, which is transported from the sheet feeding cassette 102 using the transport unit 105, to hold on to the surface (outer peripheral surface) of the holding roller 104 by being adsorbed. The holding unit 106 causes the recording sheet P to be adsorbed to the holding roller 104 using an electrostatic force due to charging, after pressing the recording sheet P to the holding roller 104.

The image forming unit 107 forms an image on the recording sheet P, which is held onto the outer surface of the holding roller 104 using the holding unit 106. The image forming unit 107 includes the plurality of ink jet heads 1 that face the surface of the holding roller 104. The plurality of ink jet heads 1 form an image by ejecting ink of four colors (e.g., cyan, magenta, yellow, and black) onto the recording sheet P, respectively.

The neutralizing and separating unit 108 separates the recording sheet P from the holding roller 104 by performing neutralizing with respect to the recording sheet on which an image is formed. The neutralizing and separating unit 108 performs neutralizing with respect to the recording sheet P by providing a charge, and inserts a claw between the recording sheet P and the holding roller 104. In this manner, the recording sheet P is separated from the holding roller 104. The recording sheet P separated from the holding roller 104 is transported to the sheet discharging tray 103 or the reversing unit 109 using the transport unit 105.

The reversing unit 109 turns the recording sheet P inside out, which is separated from the holding roller 104, and supplies the recording sheet P onto the surface of the holding roller 104 again. The reversing unit 109 reverses the recording sheet P by transporting the recording sheet P along a predetermined reversing path which causes the recording sheet P to switch back in an opposite direction in the anterior-posterior direction, for example.

The cleaning unit 110 cleans the holding roller 104. The cleaning unit 110 is located on the downstream side of the neutralizing and separating unit 108 in a rotating direction of the holding roller 104. The cleaning unit 110 cleans the surface of the holding roller 104 which rotates, by bringing a cleaning member 110a into contact with the surface of the holding roller 104 which rotates.

According to embodiments, it is possible to provide an ink jet head and an ink jet recording apparatus that can reliably maintain an electrical connection even when any one of the common electrodes in a high density nozzle is disconnected.

## Claims

1. An ink jet head (1), comprising:
a plurality of nozzles arranged in two directions in an array with intervals therebetween; and
a plurality of actuators (6), corresponding to this plurality of nozzles (17), configured to eject ink from the plurality of nozzles by pressurizing the ink,
a flow path substrate (2),
a plurality of mounting pads (9),
a first wiring pattern (19) including a plurality of individual electrodes (7) each individual electrode (7) being connected to each actuator (6) individually and independently,
a second wiring pattern (20) including a plurality of common electrodes (8a, 8b, 8c), a first common electrode (8b) electrically connected to a mounting pad (9) at an end portion and Z a second common electrode (8a) electrically connected to actuators (6) that are adjacent to each other,
the plurality of actuators (6), the plurality of individual electrodes (7), the plurality of common electrodes (8a, 8b, 8c) Z and the plurality of mounting pads (9) are formed on the flow path substrate (2),
wherein each of the plurality of actuators (6) includes a piezoelectric body (12) disposed on a vibrating plate (10), an actuator common electrode (13) electrically connected to the piezoelectric body (12), and an actuator individual electrode (11) electrically connected to the piezoelectric body (12), the piezoelectric body being interposed between the actuator individual electrode (11) and the actuator common electrode (13), a stacked body of the actuator individual electrode (11), the piezoelectric body (12), and the **actuator** common electrode (13) being formed on the vibrating plate (10) in a toroidal shape around the nozzle (17),
each actuator individual electrode (11) of the plurality of actuators is electrically connected to one of the individual electrodes (7) of the first wiring pattern (19) disposed on the vibrating plate (10),
each actuator common electrode (13) of the plurality of actuators is connected to the second wiring pattern (20) disposed on the vibrating plate (10) separated from the first wiring pattern (19), the second wiring pattern (20) being electrically connected to a wiring portion that passes between the outer peripheral portions of the plural piezoelectric bodies (12), **characterized in that**:
a third wiring pattern (21) is disposed on the vibrating plate (10), extends in a direction different from a direction of the second common electrode (8a) of the second wiring pattern (20), and is electrically connected to the second wiring pattern (20) at intersections with the
second common electrode (8a) or through a third common electrode (8c) included in the second wiring pattern (20) and which branches off from the Z second common electrode (8a), and
the first wiring pattern (19) and the third wiring pattern (21) are electrically isolated at intersections thereof.

2. The ink jet head according to claim 1,
wherein the second common electrode (8a) of each of the plurality of actuators has at least two current paths (M, N) in the second wiring pattern (20) and the third wiring pattern (21).

3. The ink jet head according to claim 2, wherein the at least two current paths include first and second main current paths in a common second wiring pattern.

4. The ink jet head according to claim 2 or 3, wherein the at least two current paths include first, second, and third current sub-paths in the third wiring pattern from the first main current path in the second wiring pattern.

5. The ink jet head according to claim 4, wherein the at least two current paths include third and fourth current sub-paths in the third wiring pattern from the second main current path in the second wiring pattern.

6. The ink jet head according to any one of claims 1 to 5,
wherein an insulating layer is interposed between the first and third wiring patterns at intersecting portions thereof.

7. The ink jet head according to any one of claims 1 to 6,
wherein each individual electrode of the plurality of actuators is connected to the first wiring pattern as an address, and
wherein each common electrode of the plurality of actuators is connected to the second wiring pattern and the third wiring pattern as a ground.

8. The ink jet head according to any one of claims 1 to 7, wherein the second wiring pattern and the third wiring pattern are separate wiring patterns.

9. The ink jet head according to any one of claims 1 to 7, wherein the second wiring pattern and the third wiring pattern are integrated.

10. The ink jet head according to any one of claims 1 to 9, wherein the first wiring pattern and the second wiring pattern are electrically coupled to mounting pads.

11. An ink jet recording apparatus (100), comprising:
a transport unit (105) configured to transport a recording sheet;
a holding unit (106) configured to hold the recording sheet transported by the transport unit on a surface of a holding roller; and
an imaging forming unit (107) configured to form an image on the recording sheet, the imaging forming unit including the ink jet head according to any one of claims 1 to 10.

12. An ink jet recording system, comprising:
a transport means configured to transport a recording sheet;
a holding means configured to hold the recording sheet transported by the transport means on a surface of a holding roller; and
an imaging forming means configured to form an image on the recording sheet, the imaging forming means including the ink jet head according to any one of claims 1 to 10.

13. A method for performing an ink jet recording, comprising the steps of:
- transporting a recording sheet (P) by a transport unit (105);
- holding, by a holding unit (106), the recording sheet transported by the transport unit on a surface of a holding roller; and
- forming an image on the recording sheet by an imaging forming unit (107), the imaging forming unit including the ink jet head according to any one of claims 1 to 10.

## Patentansprüche

1. Tintenstrahl-Druckkopf (1), Folgendes umfassend:
mehrere Düsen, die in zwei Richtungen in einem Feld mit Abständen dazwischen angeordnet sind, und
mehrere Betätigungselemente (6), die diesen mehreren Düsen (17) entsprechen und dafür konfiguriert sind, Tinte aus den mehreren Düsen auszustoßen, indem die Tinte mit Druck beaufschlagt wird,
ein Fließwegsubstrat (2),
mehrere Montage-Pads (9),
eine erste Verdrahtungsstruktur (19), die mehrere individuelle Elektroden (7) beinhaltet, wobei jede individuelle Elektrode (7) individuell und unabhängig mit jedem Betätigungselement (6) verbunden ist,
eine zweite Verdrahtungsstruktur (20), die mehrere gemeinsame Elektroden (8a, 8b, 8c) beinhaltet, wobei eine erste gemeinsame Elektrode (8b) an einem Endabschnitt elektrisch mit einem Montage-Pad (9) verbunden ist und eine zweite gemeinsame Elektrode (8a) elektrisch mit Betätigungselementen (6) verbunden ist, die nebeneinander liegen,
wobei die mehreren Betätigungselemente (6), die mehreren individuellen Elektroden (7), die mehreren gemeinsamen Elektroden (8a, 8b, 8c) und die mehreren Montage-Pads (9) auf dem Fließwegsubstrat (2) gebildet sind,
wobei jedes der mehreren Betätigungselemente (6) einen piezoelektrischen Körper (12), der auf einer vibrierenden Platte (10) angeordnet ist, eine gemeinsame Betätigungselementelektrode (13), die elektrisch mit dem piezoelektrischen Körper (12) verbunden ist, und eine individuelle Betätigungselementelektrode (11), die elektrisch mit dem piezoelektrischen Körper (12) verbunden ist, beinhaltet, wobei der piezoelektrische Körper zwischen der individuellen Betätigungselementelektrode (11) und der gemeinsamen Betätigungselementelektrode (13) eingesetzt ist, wobei ein gestapelter Körper der individuellen Betätigungselementelektrode (11), der piezoelektrische Körper (12) und die gemeinsame Betätigungselementelektrode (13) in einer Ringform um die Düse (17) herum auf der vibrierenden Plate (10) gebildet sind,
jede individuelle Betätigungselementelektrode (11) der mehreren Betätigungselemente elektrisch mit einer der individuellen Elektroden (7) der ersten Verdrahtungsstruktur (19) verbunden ist, die auf der vibrierenden Platte (10) angeordnet ist,
wobei jede gemeinsame Betätigungselementelektrode (13) der mehreren Betätigungselemente mit der zweiten Verdrahtungsstruktur (20) verbunden ist, die getrennt von der ersten Verdrahtungsstruktur (19) auf der vibrierenden Platte (10) angeordnet ist, wobei die zweite Verdrahtungsstruktur (20) elektrisch mit einem Verdrahtungsabschnitt verbunden ist, der zwischen den Außenumfangsabschnitten der mehreren piezoelektrischen Körper (12) verläuft,
**dadurch gekennzeichnet, dass**:
eine dritte Verdrahtungsstruktur (21) auf der vibrierenden Platte (10) angeordnet ist, sich in eine Richtung erstreckt, die sich von einer Richtung der zweiten gemeinsamen Elektrode (8a) der zweiten Verdrahtungsstruktur (20) unterscheidet, und an Schnittpunkten mit der zweiten gemeinsamen Elektrode (8a) oder durch eine dritte gemeinsame Elektrode (8c), die in der zweiten Verdrahtungsstruktur (20) enthalten ist und von der zweiten gemeinsamen Elektrode (8a) abzweigt, elektrisch mit der zweiten Verdrahtungsstruktur (20) verbunden ist, und
die erste Verdrahtungsstruktur (19) und die dritte Verdrahtungsstruktur (21) an ihren Schnittpunkten elektrisch isoliert sind.

2. Tintenstrahl-Druckkopf nach Anspruch 1, wobei die zweite gemeinsame Elektrode (8a) von jedem der mehreren Betätigungselemente mindestens zwei Stromwege (M, N) in der zweiten Verdrahtungsstruktur (20) und der dritten Verdrahtungsstruktur (21) aufweist.

3. Tintenstrahl-Druckkopf nach Anspruch 2, wobei die mindestens zwei Stromwege einen ersten und einen zweiten Hauptstromweg in einer gemeinsamen zweiten Verdrahtungsstruktur beinhalten.

4. Tintenstrahl-Druckkopf nach Anspruch 2 oder 3, wobei die mindestens zwei Stromwege in der dritten Verdrahtungsstruktur einen ersten, einen zweiten und einen dritten Stromteilweg von dem ersten Hauptstromweg in der zweiten Verdrahtungsstruktur beinhalten.

5. Tintenstrahl-Druckkopf nach Anspruch 4, wobei die mindestens zwei Stromwege in der dritten Verdrahtungsstruktur einen dritten und einen vierten Stromteilweg von dem zweiten Hauptstromweg in der zweiten Verdrahtungsstruktur beinhalten.

6. Tintenstrahl-Druckkopf nach einem der Ansprüche 1 bis 5, wobei zwischen der ersten und der dritten Verdrahtungsstruktur an deren sich schneidenden Abschnitten eine Isolationsschicht eingesetzt ist.

7. Tintenstrahl-Druckkopf nach einem der Ansprüche 1 bis 6,
wobei jede individuelle Elektrode der mehreren Betätigungselemente mit der ersten Verdrahtungsstruktur als eine Adresse verbunden ist und
wobei jede gemeinsame Elektrode der mehreren Betätigungselemente mit der zweiten Verdrahtungsstruktur und der dritten Verdrahtungsstruktur als eine Masse verbunden ist.

8. Tintenstrahl-Druckkopf nach einem der Ansprüche 1 bis 7, wobei die zweite Verdrahtungsstruktur und die dritte Verdrahtungsstruktur separate Verdrahtungsstrukturen sind.

9. Tintenstrahl-Druckkopf nach einem der Ansprüche 1 bis 7, wobei die zweite Verdrahtungsstruktur und die dritte Verdrahtungsstruktur integriert sind.

10. Tintenstrahl-Druckkopf nach einem der Ansprüche 1 bis 9, wobei die erste Verdrahtungsstruktur und die zweite Verdrahtungsstruktur elektrisch an Montage-Pads gekoppelt sind.

11. Tintenstrahl-Aufzeichnungsvorrichtung (100), Folgendes umfassend:
eine Transporteinheit (105), die dafür gestaltet ist, einen Aufzeichnungsbogen zu transportieren,
eine Halteeinheit (106), die dafür gestaltet ist, den Aufzeichnungsbogen, der von der Transporteinheit transportiert wird, auf einer Oberfläche einer Haltewalze zu halten, und
eine Bildbildungseinheit (107), die dafür gestaltet ist, ein Bild auf dem Aufzeichnungsbogen zu bilden, wobei die Bildbildungseinheit den Tintenstrahl-Druckkopf nach einem der Ansprüche 1 bis 10 beinhaltet.

12. Tintenstrahl-Aufzeichnungssystem, Folgendes umfassend:
ein Transportmittel, das dafür gestaltet ist, einen Aufzeichnungsbogen zu transportieren,
ein Haltemittel, das dafür gestaltet ist, den Aufzeichnungsbogen, der von dem Transportmittel transportiert wird, auf einer Oberfläche einer Haltewalze zu halten, und
ein Bildbildungsmittel, das dafür gestaltet ist, ein Bild auf dem Aufzeichnungsbogen zu bilden, wobei das Bildbildungsmittel den Tintenstrahl-Druckkopf nach einem der Ansprüche 1 bis 10 beinhaltet.

13. Verfahren zum Durchführen einer Tintenstrahlaufzeichnung, folgende Schritte umfassend:
- Transportieren eines Aufzeichnungsbogens (P) durch eine Transporteinheit (105),
- Halten des von der Transporteinheit transportierten Aufzeichnungsbogens auf einer Oberfläche einer Haltewalze durch eine Halteeinheit (106) und
- Bilden eines Bildes auf dem Aufzeichnungsbogen durch eine Bildbildungseinheit (107), wobei die Bildbildungseinheit den Tintenstrahl-Druckkopf nach einem der Ansprüche 1 bis 10 beinhaltet.

## Revendications

1. Tête à jet d'encre (1), comprenant :
une pluralité de buses disposées dans deux directions dans un réseau avec des intervalles entre elles ; et
une pluralité d'actionneurs (6), qui correspondent à ladite pluralité de buses (17), configurés pour éjecter de l'encre de la pluralité de buses en pressurisant l'encre,
un substrat de trajet d'écoulement (2),
une pluralité de plots de montage (9),
un premier motif de câblage (19) comprenant une pluralité d'électrodes individuelles (7), chaque électrode individuelle (7) étant reliée à chaque actionneur (6) individuellement et indépendamment,
un second motif de câblage (20) comprenant une pluralité d'électrodes communes (8a, 8b, 8c) une première électrode commune (8b) reliée électriquement à un plot de montage (9) au niveau d'une partie d'extrémité et une seconde électrode commune (8a) reliée électriquement à des actionneurs (6) qui sont adjacents les uns aux autres, la pluralité d'actionneurs (6), la pluralité d'électrodes individuelles (7), la pluralité d'électrodes communes (8a, 8b, 8c) et la pluralité de plots de montage (9) étant formés sur le substrat de trajet d'écoulement (2),
dans laquelle chacun de la pluralité d'actionneurs (6) comprend un corps piézoélectrique (12) disposé sur une plaque vibrante (10), une électrode commune d'actionneur (13) reliée électriquement au corps piézoélectrique (12), et une électrode individuelle d'actionneur (11) reliée électriquement au corps piézoélectrique (12), le corps piézoélectrique étant interposé entre l'électrode individuelle d'actionneur (11) et l'électrode commune d'actionneur (13), un corps empilé de l'électrode individuelle d'actionneur (11), le corps piézoélectrique (12) et l'électrode commune d'actionneur (13) étant formés sur la plaque vibrante (10) avec une forme toroïdale autour de la buse (17),
chaque électrode individuelle d'actionneur (11) de la pluralité d'actionneurs est reliée électriquement à l'une des électrodes individuelles (7) du premier motif de câblage (19) disposé sur la plaque vibrante (10),
chaque électrode commune d'actionneur (13) de la pluralité d'actionneurs est reliée au second motif de câblage (20) disposé sur la plaque vibrante (10) et séparé du premier motif de câblage (19), le second motif de câblage (20) étant relié électriquement à une partie de câblage qui passe entre les parties périphériques externes des corps piézoélectriques (12), **caractérisé en ce que** :
un troisième motif de câblage (21) est disposé sur la plaque vibrante (10), s'étend dans une direction différente d'une direction de la seconde électrode commune (8a) du second motif de câblage (20), et est relié électriquement au second motif de câblage (20) aux intersections avec la seconde électrode commune (8a) ou à travers une troisième électrode commune (8c) incluse dans le second motif de câblage (20) et qui est dérivée de la seconde électrode commune (8a), et
le premier motif de câblage (19) et le troisième motif de câblage (21) sont isolés électriquement aux intersections de ceux-ci.

2. Tête à jet d'encre selon la revendication 1,
dans laquelle la seconde électrode commune (8a) de chacun de la pluralité d'actionneurs possède au moins deux trajets de courant (M, N) dans le second motif de câblage (20) et le troisième motif de câblage (21).

3. Tête à jet d'encre selon la revendication 2, dans laquelle les au moins deux trajets de courant comprennent un premier et un second trajets de courant principaux dans un second motif de câblage commun.

4. Tête à jet d'encre selon la revendication 2 ou 3, dans laquelle les au moins deux trajets de courant comprennent un premier, un second et un troisième sous-trajets dans le troisième motif de câblage depuis le premier trajet de courant principal dans le second motif de câblage.

5. Tête à jet d'encre selon la revendication 4, dans laquelle les au moins deux trajets de courant comprennent un troisième et un quatrième sous-trajets dans le troisième motif de câblage depuis le second trajet de courant principal dans le second motif de câblage.

6. Tête à jet d'encre selon l'une quelconque des revendications 1 à 5,
dans laquelle une couche d'isolation est interposée entre le premier et le troisième motifs de câblage au niveau des parties d'intersection de ceux-ci.

7. Tête à jet d'encre selon l'une quelconque des revendications 1 à 6,
dans laquelle chaque électrode individuelle de la pluralité d'actionneurs est reliée au premier motif de câblage en guise d'adresse, et
dans laquelle chaque électrode commune de la pluralité d'actionneurs est reliée au second motif de câblage et au troisième motif de câblage en guise de terre.

8. Tête à jet d'encre selon l'une quelconque des revendications 1 à 7, dans laquelle le second motif de câblage et le troisième motif de câblage sont des motifs de câblage distincts.

9. Tête à jet d'encre selon l'une quelconque des revendications 1 à 7, dans laquelle le second motif de câblage et le troisième motif de câblage sont intégrés.

10. Tête à jet d'encre selon l'une quelconque des revendications 1 à 9, dans laquelle le premier motif de câblage et le second motif de câblage sont reliés électriquement à des plots de montage.

11. Appareil d'enregistrement à jet d'encre (100), comprenant :
une unité de transport (105) configurée pour transporter une feuille d'enregistrement ;
une unité de maintien (106) configurée pour maintenir la feuille d'enregistrement transportée par l'unité de transport sur une surface d'un rouleau de maintien ; et
une unité de formation d'image (107) configurée pour former une image sur la feuille d'enregistrement, l'unité de formation d'image comprenant la tête à jet d'encre selon l'une quelconque des revendications 1 à 10.

12. Système d'enregistrement à jet d'encre, comprenant :
un moyen de transport configuré pour transporter une feuille d'enregistrement ;
un moyen de maintien configuré pour maintenir la feuille d'enregistrement transportée par le moyen de transport sur une surface d'un rouleau de maintien ; et
un moyen de formation d'image configuré pour former une image sur la feuille d'enregistrement, le moyen de formation d'image comprenant la tête à jet d'encre selon l'une quelconque des revendications 1 à 10.

13. Procédé d'enregistrement à jet d'encre, comprenant les étapes consistant à :
- transporter une feuille d'enregistrement (P) par une unité de transport (105) ;
- maintenir, par une unité de maintien (106), la feuille d'enregistrement transportée par l'unité de transport sur une surface d'un rouleau de maintien ; et
- former une image sur la feuille d'enregistrement par une unité de formation d'image (107), l'unité de formation d'image comprenant la tête à jet d'encre selon l'une quelconque des revendications 1 à 10.
